# EUROPEAN PATENT APPLICATION

(11) **EP 2 450 966 A2**
(43) Date of publication of application: **09.05.2012**
(21) Application number: 10794367.2
(22) Date of filing: 30.06.2010
(51) Int. Cl.: H01L 31/042

(54) **SOLAR BATTERY AND A PRODUCTION METHOD FOR SAME**

(30) Priority: 30.06.2009 KR 20090059517
(71) Applicant: LG Innotek Co., Ltd., Seoul 100-714 (KR)
(72) Inventor: LEE, Dong Keun, Seoul 100-714 (KR)
(74) Representative: Novagraaf Technologies
(86) International application number: PCT/KR2010/004258
(87) International publication number: WO 2011/002232

(57) **Abstract**

A solar battery includes: a plurality of rear electrode patterns, a light absorption layer, a front electrode, an interconnection, a separation pattern, and a dummy layer. The rear electrode patterns are disposed on a substrate and spaced apart from each other. The light absorption layer is disposed on the rear electrode patterns. The front electrode is disposed on the light absorption layer. The interconnection is a part of the front electrode penetrating the light absorption layer and electrically connected to the rear electrode patterns. The separation pattern penetrates the light absorption layer and the front electrode for defining unit cells. The dummy layer is disposed between the interconnection and the separation pattern. The dummy layer has a top surface lower than that of the front electrode.

## Description

### [Technical Field]

The present disclosure relates to a solar battery and a method for manufacturing the solar battery.

### [Background Art]

As the consumption of energy increases, research has been conducted on solar batteries for converting solar energy into electric energy.

Particularly, Cu(In,Ga)Se₂ (CIGS) solar batteries are widely used, which are a pn hetero junction devices having a substrate structure including a glass substrate, a metal rear electrode layer, a p-type CIGS light absorption layer, a high resistance buffer layer, and an n-type window layer.

In such a solar battery, cells are defined by a separation pattern formed by etching a light absorption layer, a buffer layer, and a front electrode (an n-type window layer). However, due to particles generating during a process of forming the separation pattern, cells may become defective, and thus the solar battery may malfunction.

### [Disclosure]

### [Technical Problem]

Embodiments provide a solar battery and a method for manufacturing the solar batter, so that solar battery manufacturing processes can be simplified and particles can be reduced during the processes so as to minimize defects.

### [Technical Solution]

In an embodiment, a solar battery includes: a plurality of rear electrode patterns disposed on a substrate and spaced apart from each other; a light absorption layer on the rear electrode patterns; a front electrode on the light absorption layer; an interconnection which is a part of the front electrode penetrating the light absorption layer and electrically connected to the rear electrode patterns; a separation pattern penetrating the light absorption layer and the front electrode for defining unit cells; and a dummy layer between the interconnection and the separation pattern. The dummy layer may have a top surface lower than that of the front electrode.

In another embodiment, a solar battery includes: a plurality of rear electrode patterns disposed on a substrate and spaced apart from each other; a light absorption layer, a first buffer layer, and a second buffer layer on the rear electrode patterns; a front electrode on the second buffer layer; an interconnection which is parts of the second buffer layer and the front electrode penetrating the light absorption layer and the first buffer layer and electrically connected to the rear electrode patterns; and a separation pattern penetrating the light absorption layer, the first buffer layer, the second buffer layer, and the front electrode for defining unit cells. The interconnection may be formed by a stack of the second buffer layer and the front electrode.

In another embodiment, there is provided a method for manufacturing a solar battery, the method includes: forming a plurality of rear electrode patterns spaced apart from each other on a substrate; forming a light absorption layer and a first buffer layer on the substrate where the rear electrode patterns are formed; forming a contact pattern and a separation pattern that penetrate the light absorption layer and the first buffer layer; and forming a front electrode on a front side of the substrate by using a mask covering a dummy layer and the seperation pattern, the dummy layer comprising parts of the light absorption layer and the first buffer layer disposed between the contact pattern and the separation pattern. After the front electrode is formed, the dummy layer and the rear electrode patterns close to the separation pattern are exposed.

### [Advantageous Effects]

According to the solar cell and the solar cell manufacturing method of the embodiments, after forming the light absorption layer, the buffer layer, the contact pattern, and the separation pattern, the front electrode is formed using the mask. Therefore, processes can be simplified.

In addition, after the front electrode is formed, it is not necessary to partially remove the front electrode to form the separation pattern. This prevents defects caused by contaminants generating if the front electrode is partially removed.

### [Description of Drawings]

Figs. 1 to 5 are sectional view for explaining a method for manufacturing a solar battery according to a first embodiment

Figs. 6 and 7 are sectional view for explaining a method for manufacturing a solar battery according to a modification example of the first embodiment.

Figs. 8 to 12 are sectional view for explaining a method for manufacturing a solar battery according to a second embodiment.

Figs. 13 and 14 are sectional views for explaining a method for manufacturing a solar battery according to a modification example of the second embodiment.

### [Best Mode]

In the following description, it will be understood that when a substrate, a layer (or film), or an electrode is referred to as being 'on' another substrate, layer, or electrode, it can be directly on the other substrate, layer or electrode, or one or more intervening substrates, layers, or electrodes may also be present. Further, it will be understood that when a substrate, a layer, or an electrode is referred to as being 'under' another substrate, layer, or electrode, it can be directly under the other substrate, layer, or electrode, or one or more intervening substrates, layers, or electrodes may also be present. In addition, it will also be understood that when a layer is referred to as being 'between' two layers, it can be the only layer between the two layers, or one or more intervening layers may also be present. Further, the reference about 'on' and 'under' each layer will be made on the basis of drawings. Also, in the drawings, the sizes of elements may be exaggerated for clarity of illustration, and the size of each element does not entirely reflect an actual size.

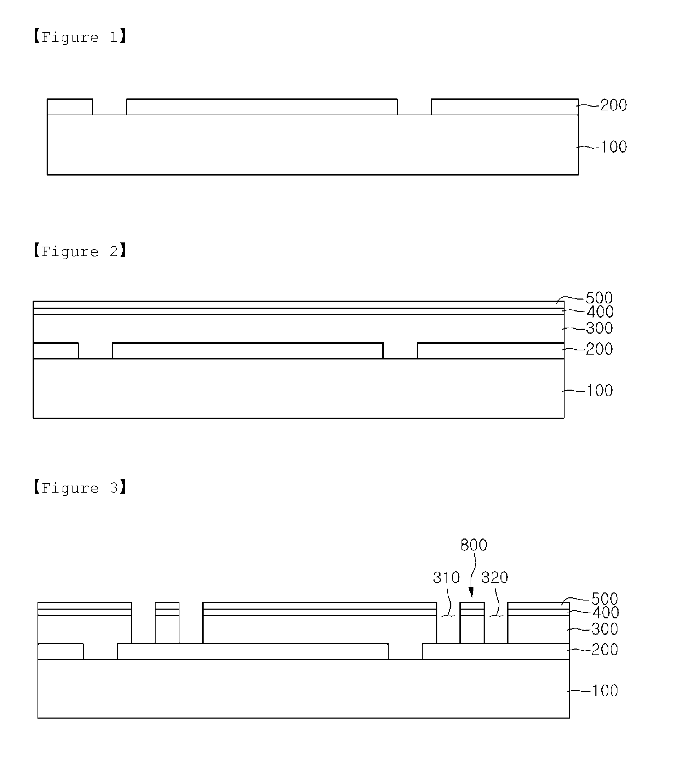

With reference to Figs. 1 to 7, a method for manufacturing a solar battery and a solar battery made by the method will be described in detail according to a first embodiment and a modification example of the first embodiment.

Figs. 1 to 5 are sectional view for explaining a method for manufacturing a solar battery according to the first embodiment.

First, as shown in Fig. 1, rear electrode patterns 200 are formed on a substrate 100.

The substrate 100 may be a glass substrate. Alternatively, the substrate 100 may be a ceramic substrate such as an alumina substrate, a stainless steel substrate, a titanium substrate, or a polymer substrate.

In case of using a glass substrate, a sodalime glass substrate may be used. In case of using a polymer substrate, a polyimide substrate may be used.

In addition, the substrate 100 may be rigid or flexible.

The rear electrode patterns 200 may be formed by forming a rear electrode layer and patterning the rear electrode layer.

In addition, the rear electrode patterns 200 may be arranged in a stripe or matrix shape corresponding to cells.

However, the shape of the rear electrode pattern 200s is not limited to the above-mentioned shapes. The rear electrode patterns 200 may have various shapes.

The rear electrode patterns 200 may be formed of a conductive material such as a metal.

For example, the rear electrode patterns 200 may be formed through a sputtering process using molybdenum (Mo) as a target.

In this case, owing to high electric conductivity of molybdenum (Mo), the rear electrode patterns 200 may make ohmic contacts with a light absorption layer and be stable even at a high temperature under a selenium (Se) atmosphere.

Although not shown in the drawings, the rear electrode patterns 200 may be constituted by at least one layer.

In the case where the rear electrode patterns 200 are constituted by a plurality of layers, the layers may be formed of different materials.

Next, as shown in Fig. 2, a light absorption layer 300, a first buffer layer 400, and a second buffer layer 500 are formed on the rear electrode patterns 200.

The light absorption layer 300 may be formed of a group Ib-IIIb-VIb compound.

For example, the light absorption layer 300 may include a Cu(In, Ga)Se₂ (CIGS) compound.

Alternatively, the light absorption layer 300 may include a CuInSe₂ (CIS) compound or CuGaSe₂ (CGS) compound.

For example, a CIG metal precursor layer is formed on the rear electrode patterns 200 by using a copper target, an indium target, and a gallium target so as to form the light absorption layer 300.

Then, the metal precursor layer reacts with selenium (Se) in a selenization process, thereby forming a CIGS light absorption layer 300.

In addition, during the metal precursor forming process and the selenization process, an alkali component included in the substrate 100 diffuses to the metal precursor layer and the light absorption layer 300 through the rear electrode patterns 200.

The alkali component may increase grain sizes of the light absorption layer 300 and improve crystalline properties of the light absorption layer 300.

Alternatively, the light absorption layer 300 may be formed by a co-evaporation method using copper (Cu), indium (In), gallium (Ga), and selenium (Se).

The light absorption layer 300 receives light and converts the light into electrical energy. The light absorption layer 300 generates a photoelectromotive force by the photovoltaic effect.

The first buffer layer 400 may be formed by depositing cadmium sulfide (CdS) on the light absorption layer 300.

At this time, the first buffer layer 400 is an n-type semiconductor layer, and the light absorption layer 300 is a p-type semiconductor layer. Therefore, the light absorption layer 300 and the first buffer layer 400 form a pn junction.

The second buffer layer 500 may be a transparent electrode layer including one of ITO, ZnO, and i-ZnO.

The first buffer layer 400 and the second buffer layer 500 are formed between the light absorption layer 300 and a front electrode to be formed later.

That is, since the light absorption layer 300 and the front electrode are largely different in lattice constant and energy band gap, the first buffer layer 400 and the second buffer layer 500 having medium band gaps are interposed for a good junction.

In the current embodiment, two buffer layers are formed on the light absorption layer 300. However, the current embodiment is not limited thereto. For example, only one buffer layer may be formed.

Next, as shown in Fig. 3, a contact pattern 310 and a separation pattern 320 are formed through the light absorption layer 300, the first buffer layer 400, and the second buffer layer 500.

The contact pattern 310 and the separation pattern 320 may be formed by using a mechanical method or irradiating a laser beam, and the rear electrode patterns 200 may be partially exposed through the contact pattern 310 and the separation pattern 320.

The contact pattern 310 and the separation pattern 320 may be formed sequentially or simultaneously.

At this time, the light absorption layer 300, the first buffer layer 400, and the second buffer layer 500 form a dummy layer 800 between the contact pattern 310 and the separation pattern 320.

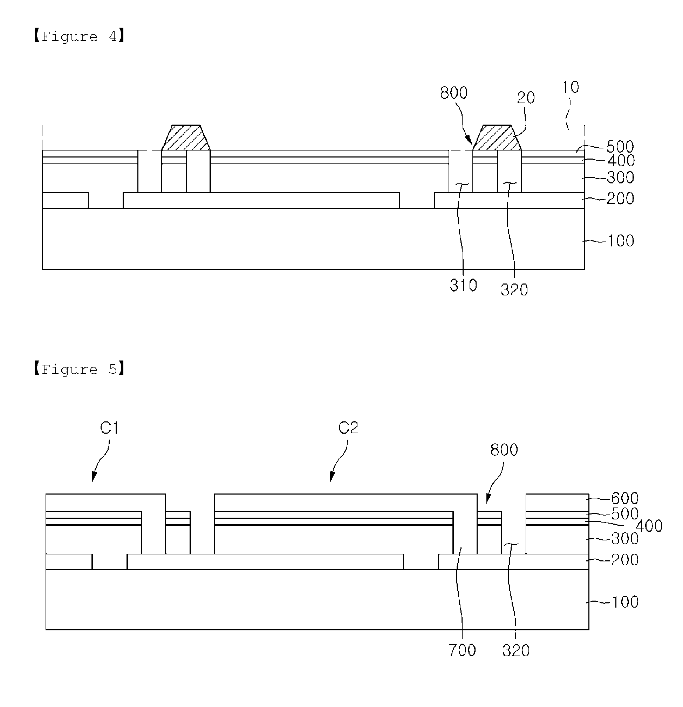

Next, as shown in Fig. 4, a mask 10 is disposed on the second buffer layer 500.

The mask 10 covers the dummy layer 800 and the separation pattern 320 but does not cover the other region.

A side surface 20 of the mask 10 may be sloped in a manner such that the side surface 20 becomes wider as it goes downward.

In this case, when a front electrode is formed in a later process, deposition of the front electrode on the second buffer layer 500 may not be affected by a substance deposited on the mask 10.

That is, if the side surface 20 of the mask 10 is not sloped, the contact pattern 310 may be partially blocked by a part of the front electrode deposited on the mask 10, and thus the front electrode may not be deposited in the contact pattern 310. In this case, the front electrode may not make contact with the rear electrode patterns 200.

Next, as shown in Fig. 5, a transparent conductive front electrode 600 is formed on the substrate 100 by using the mask 10.

When the transparent conductive front electrode 600 is formed on the second buffer layer 500, the front electrode 600 is also formed in the contact pattern 310 to form interconnections 700.

The rear electrode patterns 200 and the front electrode 600 are electrically connected through the interconnections 700.

For example, first and second cells C1 and C2 can be connected to each other through the interconnections 700. For example, the rear electrode pattern 200 of the second cell C2 is connected to the front electrode 600 of the first cell C1 neighboring the second cell C2 through the interconnection 700.

At this time, since the front electrode 600 is formed by using the mask 10, the front electrode 600 is not formed on the separation pattern 320 and the dummy layer 800.

That is, after the front electrode 600 is formed, the second buffer layer 500 of the dummy layer 800, and the rear electrode patterns 200 are exposed.

In addition, since the front electrode 600 is not formed on the dummy layer 800, the upper part of the separation pattern 320 close to the front electrode 600 may be wider than the lower part of the separation pattern 320 close to the rear electrode patterns 200.

In the current embodiment, when the contact pattern 310 is formed, the separation pattern 320 is also formed, and then the front electrode 600 is formed using the mask 10. Thus, processes can be simplified.

In addition, after the front electrode 600 is formed, it is not necessary to partially remove the front electrode 600 to form the separation pattern 320. This prevents defects caused by contaminants generating if the front electrode 600 is partially removed.

The front electrode 600 is formed on the second buffer layer 500 through a sputtering process using an aluminium doped zinc oxide.

The front electrode 600 is a window layer forming a pn junction with the light absorption layer 300. Since the front electrode 600 functions as a front transparent electrode of a solar battery, the front electrode 600 is formed of a zinc oxide (ZnO) having high optical transmittance and electric conductivity.

At this time, an electrode having a low resistance can be formed by doping an aluminium doped zinc oxide.

A zinc oxide thin film may be formed as the front electrode 600 by a radio frequency (RF) sputtering method using a ZnO target, a reactive sputtering method using a Zn target, or an organic metal chemical deposition method.

In addition, the front electrode 600 may have a dual structure formed by depositing an indium thin oxide (ITO) thin film having good electro-optical characteristics on the zinc oxide thin film.

With reference to Fig. 5, a detailed explanation will be given on the solar battery formed by the above-described solar battery manufacturing method of the first embodiment.

As shown in Fig. 5, the solar battery of the first embodiment includes the rear electrode patterns 200, the light absorption layer 300, the first buffer layer 400, the second buffer layer 500, and the front electrode 600.

The rear electrode patterns 200 are formed on the substrate 100 at a plurality of positions spaced apart from each other, and the light absorption layer 300, the first buffer layer 400, the second buffer layer 500, and the front electrode 600 are disposed on the rear electrode patterns 200.

The interconnections 700 are parts of the front electrode 600 electrically connected to the rear electrode patterns 200 through the light absorption layer 300, the first buffer layer 400, and the second buffer layer 500.

The separation pattern 320 is formed through the light absorption layer 300, the first buffer layer 400, the second buffer layer 500, and the front electrode 600.

The light absorption layer 300, the first buffer layer 400, and the second buffer layer 500 constitute the dummy layer 800 between the interconnections 700 and the contact pattern 310.

The second buffer layer 500 of the dummy layer 800 and the rear electrode patterns 200 close to the separation pattern 320 may be exposed.

In this way, the dummy layer 800 is formed by the stack of the light absorption layer 300, the first buffer layer 400, and the second buffer layer 500, and the front electrode 600 is not formed on the dummy layer 800. Therefore, the top surface of the dummy layer 800 is lower than the top surface of the front electrode 600. The reason for this is that the front electrode 600 is formed after forming the contact pattern 310 and the separation pattern 320 and covering the separation pattern 320 with the mask 10.

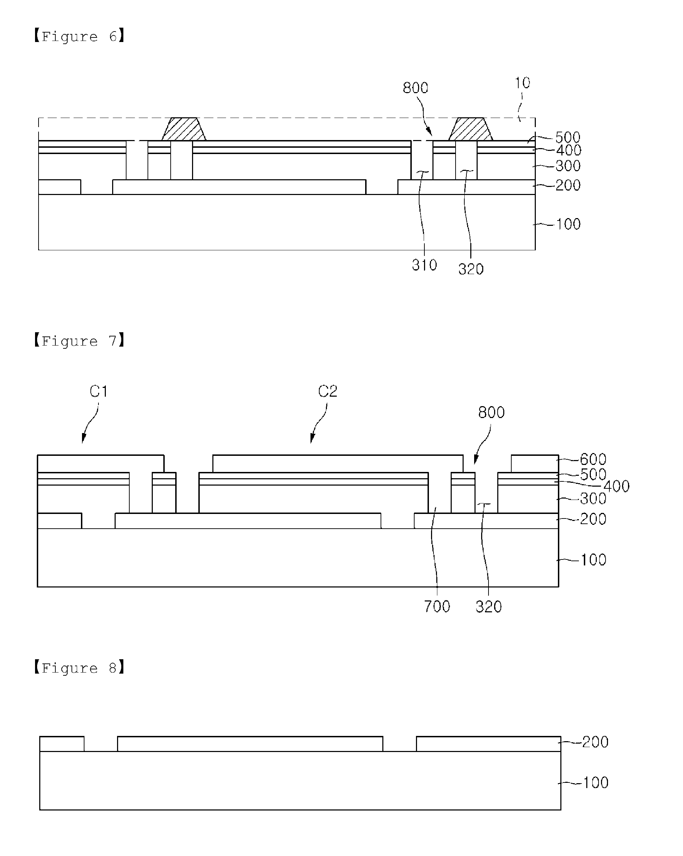

In the above-described embodiment, the mask 10 is disposed to cover the dummy layer 800 entirely and the separation pattern 320. However, the embodiment is not limited thereto. It is sufficient that the mask 10 covers the separation pattern 320, and the dummy layer 800 may be partially covered by the mask 10 as shown in Fig. 6. In this case, as shown in Fig. 7, the front electrode 600 covers the dummy layer 800 partially. Like the former case, the top surface of the dummy layer 800 is still lower than the top surface of the front electrode 600.

With reference to Figs. 8 to 14, a method for manufacturing a solar battery and a solar battery made by the method will be described in detail according to a second embodiment and a modification example of the second embodiment.

Figs. 8 to 12 are sectional view for explaining a method for manufacturing a solar battery according to the

### second embodiment.

First, as shown in Fig. 8, rear electrode patterns 200 are formed on a substrate 100.

The substrate 100 may be a glass substrate. Alternatively, the substrate 100 may be a ceramic substrate such as an alumina substrate, a stainless steel substrate, a titanium substrate, or a polymer substrate.

In case of using a glass substrate, a sodalime glass substrate may be used. In case of using a polymer substrate, a polyimide substrate may be used.

In addition, the substrate 100 may be rigid or flexible.

The rear electrode patterns 200 may be formed by forming a rear electrode layer and patterning the rear electrode layer.

In addition, the rear electrode patterns 200 may have a stripe or matrix shape corresponding to cells.

However, the shape of the rear electrode patterns 200 is not limited to the above-mentioned shapes. The rear electrode patterns 200 may have various shapes.

The rear electrode patterns 200 may be formed of a conductive material such as a metal.

For example, the rear electrode patterns 200 may be formed through a sputtering process using molybdenum (Mo) as a target.

In this case, owing to high electric conductivity of molybdenum (Mo), the rear electrode patterns 200 may make ohmic contact with a light absorption layer and be stable at a high temperature under a selenium (Se) atmosphere.

Although not shown in the drawings, the rear electrode patterns 200 may be constituted by at least one layer.

In the case where the rear electrode patterns 200 are constituted by a plurality of layers, the layers may be formed of different materials.

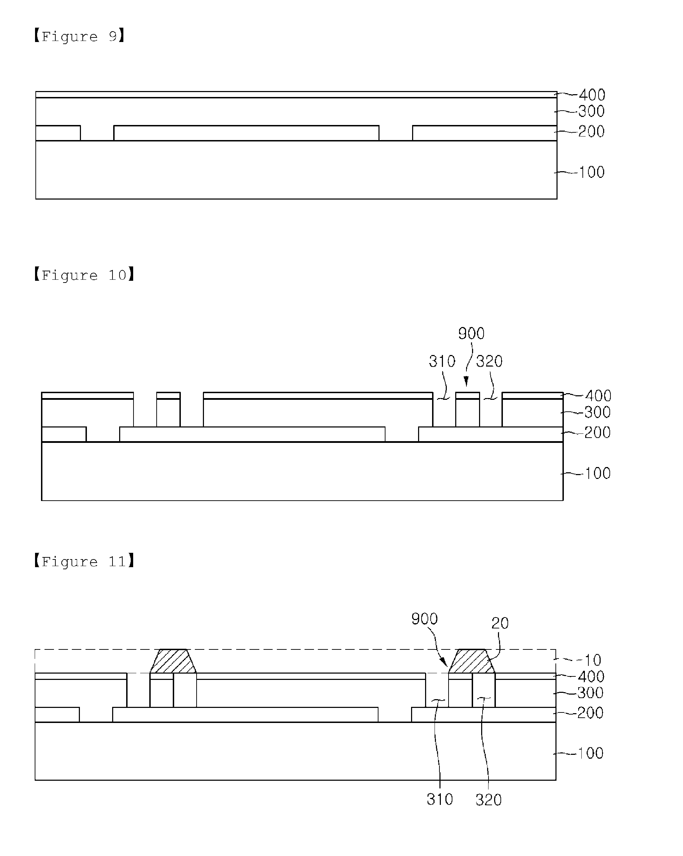

Next, as shown in Fig. 9, a light absorption layer 300 and a first buffer layer 400 are formed on the rear electrode patterns 200.

The light absorption layer 300 may be formed of a group Ib-IIIb-VIb compound.

For example, the light absorption layer 300 may include a Cu(In, Ga)Se₂ (CIGS) compound.

Alternatively, the light absorption layer 300 may include a CuInSe₂ (CIS) compound or CuGaSe₂ (CGS) compound.

For example, a CIG metal precursor layer is formed on the rear electrode patterns 200 by using a copper target, an indium target, and a gallium target so as to form the light absorption layer 300.

Then, the metal precursor layer reacts with selenium (Se) in a selenization process to form a CIGS light absorption layer 300.

In addition, during the metal precursor forming process and the selenization process, an alkali component included in the substrate 100 diffuses to the metal precursor layer and the light absorption layer 300 through the rear electrode patterns 200.

The alkali component may increase grain sizes of the light absorption layer 300 and improve crystalline properties of the light absorption layer 300.

Alternatively, the light absorption layer 300 may be formed by a co-evaporation method using copper (Cu), indium (In), gallium (Ga), and selenium (Se).

The light absorption layer 300 receives light and converts the light into electrical energy. The light absorption layer 300 generates a photoelectromotive force by the photovoltaic effect.

The first buffer layer 400 may be formed by depositing cadmium sulfide (CdS) on the light absorption layer 300.

At this time, the first buffer layer 400 is an n-type semiconductor layer, and the light absorption layer 300 is a p-type semiconductor layer. Therefore, the light absorption layer 300 and the first buffer layer 400 forms a pn junction.

Next, as shown in Fig. 10, a contact pattern 310 and a separation pattern 320 are formed through the light absorption layer 300 and the first buffer layer 400.

The contact pattern 310 and the separation pattern 320 may be formed by using a mechanical method or irradiating a laser beam, and the rear electrode patterns 200 are partially exposed through the contact pattern 310 and the separation pattern 320.

The contact pattern 310 and the separation pattern 320 may be formed sequentially or simultaneously.

At this time, the light absorption layer 300, the first buffer layer 400, and the second buffer layer 500 form a dummy layer 900 between the contact pattern 310 and the separation pattern 320.

Next, as shown in Fig. 11, a mask 10 is disposed on the second buffer layer 500.

The mask 10 covers the dummy layer 900 and the separation pattern 320 but does not cover the other region.

A side 20 of the mask 10 may be sloped in a manner such that the side 20 becomes wider as it goes downward.

In this case, when a front electrode is formed in a later process, deposition of the front electrode on the first buffer layer 400 may not be affected by a substance deposited on the mask 10.

That is, if the side surface 20 of the mask 10 is not sloped, the contact pattern 310 may be partially blocked by a part of the front electrode deposited on the mask 10, and thus the front electrode may not be deposited in the contact pattern 310. In this case, the front electrode may not make contact with the rear electrode patterns 200.

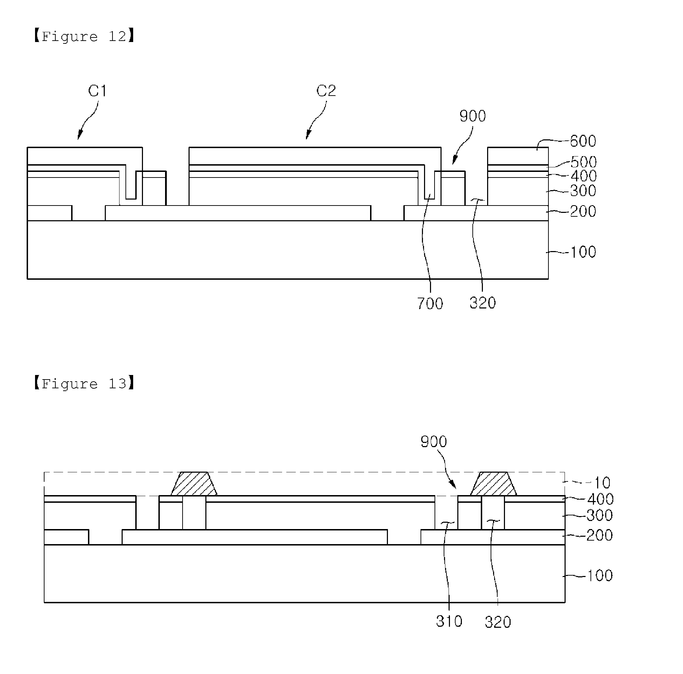

Next, as shown in Fig. 12, a second buffer layer 500 and a transparent conductive front electrode 600 are formed on the substrate 100 by using the mask 10.

The second buffer layer 500 may be a transparent electrode layer including one of ITO, ZnO, and i-ZnO.

The first buffer layer 400 and the second buffer layer 500 are disposed between the light absorption layer 300 and the front electrode 600.

That is, since the light absorption layer 300 and the front electrode are largely different in lattice constant and energy band gap, the first buffer layer 400 and the second buffer layer 500 having medium band gaps are interposed for a good junction.

In the current embodiment, two buffer layers are formed on the light absorption layer 300. However, the current embodiment is not limited thereto. For example, only one buffer layer may be formed.

When the second buffer layer 500 and the front electrode 600 are stacked on the first buffer layer 400, the second buffer layer 500 and the front electrode 600 are also formed in the contact pattern 310 to form interconnections 700.

That is, the second buffer layer 500 is formed on the bottom and side surfaces of the contact pattern 310, and then the front electrode 600 is formed in the contact pattern 310 to form the interconnections 700.

At this time, the second buffer layer 500 is disposed between the front electrode 600 and the rear electrode patterns 200.

The front electrode 600 is formed on the second buffer layer 500 through a sputtering process using a zinc oxide doped with aluminium.

The front electrode 600 is a window layer forming a pn junction with the light absorption layer 300. Since the front electrode 600 functions as a front transparent electrode of a solar battery, the front electrode 600 is formed of a zinc oxide (ZnO) having high optical transmittance and electric conductivity.

At this time, an electrode having a low resistance can be formed by doping a zinc oxide with aluminium.

A zinc oxide thin film may be formed as the front electrode 600 by a radio frequency (RF) sputtering method using a ZnO target, a reactive sputtering method using a Zn target, or an organic metal chemical deposition method.

In addition, the front electrode 600 may have a dual structure formed by depositing an indium thin oxide (ITO) thin film having good electro-optical characteristics on the zinc oxide thin film.

In the later processes, the aluminium included in the front electrode 600 may diffuse to the second buffer layer 500.

The rear electrode patterns 200 and the front electrode 600 are electrically connected through the interconnections 700.

For example, first and second cells C1 and C2 can be connected to each other through the interconnections 700. For example, the rear electrode pattern 200 of the second cell C2 is connected to the front electrode 600 of the first cell C1 neighboring the second cell C2 through the interconnection 700.

At this time, since the second buffer layer 500 and the front electrode 600 are formed by using the mask 10, the second buffer layer 500 and the front electrode 600 are not formed on the separation pattern 320 and the dummy layer 900.

That is, after the second buffer layer 500 and the front electrode 600 are formed, the first buffer layer 400 of the dummy layer 900 and the rear electrode pattern 200 are exposed.

In addition, since the second buffer layer 500 and the front electrode 600 are not formed on the dummy layer 900, the upper part of the separation pattern 320 close to the second buffer layer 500 and the front electrode 600 may be wider than the lower part of the separation pattern 320 close to the rear electrode pattern 200.

In the current embodiment, after the front electrode 600 is formed, the dummy layer 900 and the separation pattern 320 are exposed. However, the current embodiment is not limited thereto. For example, the front electrode 600 may be formed on a part of the first buffer layer 400 of the dummy layer 900 by modifying the mask 10.

That is, the first buffer layer 400 of the dummy layer 900 may be partially exposed.

In the current embodiment, when the contact pattern 310 is formed, the separation pattern 320 is also formed, and then the second buffer layer 500 and the front electrode 600 are formed using the mask 10. Thus, processes can be simplified.

In addition, after the front electrode 600 is formed, it is not necessary to partially remove the front electrode 600 to form the separation pattern 320. This prevents defects caused by contaminants generating if the front electrode 600 is partially removed.

With reference to Fig. 12, a detailed explanation will be given on the solar battery formed by the above-described solar battery manufacturing method of the second embodiment.

As shown in Fig. 12, the solar battery of the second embodiment includes the rear electrode pattern 200, the light absorption layer 300, the first buffer layer 400, the second buffer layer 500, and the front electrode 600.

The rear electrode patterns 200 are formed on the substrate 100 at a plurality of positions spaced apart from each other, and the light absorption layer 300, the first buffer layer 400, the second buffer layer 500, and the front electrode 600 are disposed on the rear electrode patterns 200.

The interconnections 700 are parts of the front electrode 600 electrically connected to the rear electrode patterns 200 through the light absorption layer 300 and the first buffer layer 400.

The separation pattern 320 is formed through the light absorption layer 300, the first buffer layer 400, the second buffer layer 500, and the front electrode 600.

The light absorption layer 300 and the first buffer layer 400 form the dummy layer 900 between the interconnections 700 and the contact pattern 310.

The first buffer layer 400 of the dummy layer 900 and the rear electrode patterns 200 close to the separation pattern 320 may be exposed.

The interconnections 700 are formed by stacks of the second buffer layer 500 and the front electrode 600.

The dummy layer 900 is formed by the stack of the light absorption layer 300 and the first buffer layer 400, and the front electrode 600 is not formed on the dummy layer 900. Therefore, the top surface of the dummy layer 900 is lower than the top surface of the front electrode 600. The reason for this is that the front electrode 600 is formed after forming the contact pattern 310 and the separation pattern 320 and covering the separation pattern 320 with the mask 10.

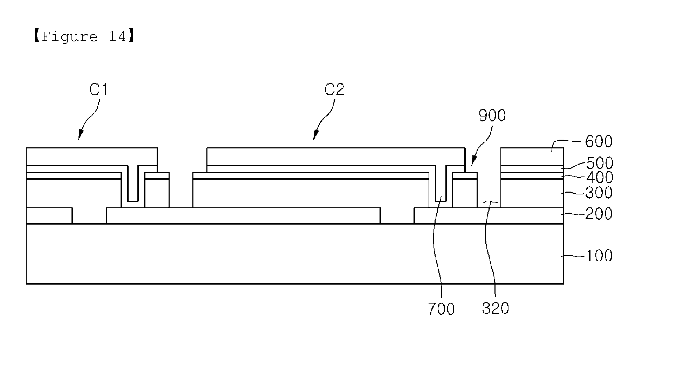

In the above-described embodiment, the mask 10 is disposed to cover the dummy layer 900 entirely and the separation pattern 320. However, the embodiment is not limited thereto. It is sufficient that the mask 10 covers the separation pattern 320, and the dummy layer 900 may be partially covered by the mask 10 as shown in Fig. 13. In this case, as shown in Fig. 14, the front electrode 600 covers the dummy layer 900 partially. Like the former case, the top surface of the dummy layer 900 is still lower than the top surface of the front electrode 600.

According to the solar battery and the solar battery manufacturing method of the embodiments, after forming the light absorption layer, the buffer layer, the contact pattern, and the separation pattern, the front electrode is formed using the mask. Therefore, processes can be simplified.

In addition, after the front electrode is formed, it is not necessary to partially remove the front electrode to form the separation pattern. This prevents defects caused by contaminants generating if the front electrode is partially removed.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A solar battery comprising:
a plurality of rear electrode patterns disposed on a substrate and spaced apart from each other;
a light absorption layer on the rear electrode patterns;
a front electrode on the light absorption layer;
an interconnection which is a part of the front electrode penetrating the light absorption layer and electrically connected to the rear electrode patterns;
a separation pattern penetrating the light absorption layer and the front electrode for defining unit cells; and
a dummy layer between the interconnection and the separation pattern,
wherein the dummy layer has a top surface lower than that of the front electrode.

2. The solar battery according to claim 1, further comprising a first buffer layer and a second buffer layer is disposed on the first buffer layer, the first buffer layer and the second buffer layer disposed between the light absorption layer and the front electrode, and
wherein the dummy layer includes a stack of the light absorption layer, the first buffer layer, and the second buffer layer.

3. The solar battery according to claim 2, wherein the second buffer layer of the dummy layer and the rear electrode patterns close to the separation pattern are exposed.

4. The solar battery according to claim 2, wherein the front electrode covers at least a part of the second buffer layer of the dummy layer.

5. The solar battery according to claim 1, further comprising a first buffer layer and a second buffer layer is disposed on the first buffer layer, the first buffer layer and the second buffer layer disposed between the light absorption layer and the front electrode, and
wherein the dummy layer includes a stack of the light absorption layer and the second buffer layer.

6. The solar battery according to claim 5, wherein the first buffer layer of the dummy layer and the rear electrode patterns close to the separation pattern are exposed.

7. The solar battery according to claim 5, wherein the second buffer layer and the front electrode cover at least a part of the first buffer layer of the dummy layer.

8. The solar battery according to claim 5, wherein the interconnection includes a stack of the second buffer layer and the front electrode.

9. The solar battery according to claim 1, wherein an upper part of the separation pattern close to the front electrode is wider than a lower part of the separation pattern close to the rear electrode patterns.

10. A solar battery comprising:
a plurality of rear electrode patterns disposed on a substrate and spaced apart from each other;
a light absorption layer, a first buffer layer, and a second buffer layer on the rear electrode patterns;
a front electrode on the second buffer layer;
an interconnection which is parts of the second buffer layer and the front electrode penetrating the light absorption layer and the first buffer layer and electrically connected to the rear electrode patterns; and
a separation pattern penetrating the light absorption layer, the first buffer layer, the second buffer layer, and the front electrode for defining unit cells;
wherein the interconnection includs a stack of the second buffer layer and the front electrode.

11. The solar battery according to claim 10, wherein the second buffer layer of the interconnection is disposed between the rear electrode patterns and the front electrode.

12. The solar battery according to claim 10, wherein a dummy layer is formed between the interconnection and the separation pattern by a stack of the light absorption layer and the first buffer layer,
wherein the first buffer layer of the dummy layer and the rear electrode patterns close to the separation pattern are exposed.

13. The solar battery according to claim 10, wherein a dummy layer is formed between the interconnection and the separation pattern by a stack of the light absorption layer and the first buffer layer,
wherein the front electrode covers a part of the first buffer layer of the dummy layer.

14. A method for manufacturing a solar battery, comprising:
forming a plurality of rear electrode patterns spaced apart from each other on a substrate;
forming a light absorption layer and a first buffer layer on the substrate where the rear electrode patterns are formed;
forming a contact pattern and a separation pattern that penetrate the light absorption layer and the first buffer layer; and
forming a front electrode on a front side of the substrate by using a mask covering a dummy layer and the seperation pattern, the dummy layer comprising parts of the light absorption layer and the first buffer layer disposed between the contact pattern and the separation pattern,
wherein after the front electrode is formed, the dummy layer and the rear electrode patterns close to the separation pattern are exposed.

15. The method according to claim 14, wherein between the forming of the light absorption layer and the first buffer layer and the forming of the contact pattern and the separation pattern, the method further comprising forming a second buffer layer on the first buffer layer,
wherein the contact pattern and the separation pattern penetrate the light absorption layer, the first buffer layer, and the second buffer layer, and
the mask covering the dummy layer and the separation pattern are disposed on the second buffer layer.

16. The method according to claim 15, wherein the dummy layer includes a stack of the light absorption layer, the first buffer layer, and the second buffer layer.

17. The method according to claim 14, wherein in the forming of the front electrode, a second buffer layer is formed by using the mask, and then the front electrode is formed on the second buffer layer.

18. The method according to claim 17, wherein the dummy layer includes a stack of the light absorption layer and the first buffer layer.

19. The method according to claim 17, wherein when the second buffer layer and the front electrode are formed, the second buffer layer and the front electrode are disposed in the contact pattern to form an interconnection,
the second buffer layer is disposed between the rear electrode patterns and the front electrode.

20. The method according to claim 19, wherein the front electrode is formed of an aluminium doped zinc oxide (ZnO), and the aluminium diffuses to the second buffer layer.
